(19) Europäisches Patentamt / European Patent Office / Office européen des brevets

(11) **EP 3 870 985 B1**

(12) **FASCICULE DE BREVET EUROPEEN**

(45) Date de publication et mention
de la délivrance du brevet:
**08.06.2022 Bulletin 2022/23**

(21) Numéro de dépôt: **19790664.7**

(22) Date de dépôt: **18.09.2019**

(51) Classification Internationale des Brevets (IPC):
**G01R 31/392** *(2019.01)*     **G01R 31/3835** *(2019.01)*

(52) Classification Coopérative des Brevets (CPC):
**G01R 31/392; G01R 31/3835;** Y02T 10/70

(86) Numéro de dépôt international:
**PCT/FR2019/052171**

(87) Numéro de publication internationale:
**WO 2020/084211 (30.04.2020 Gazette 2020/18)**

(54) **PROCEDE DE DETERMINATION DE L'ETAT DE CHARGE ET DE L'ETAT DE VIEILLISSEMENT D'UNE BATTERIE ELECTROCHIMIQUE EN FONCTION D'UNE CARTOGRAPHIE DE LA TENSION A CIRCUIT OUVERT**

VERFAHREN ZUR BESTIMMUNG DES LADEZUSTANDS UND DES ALTERUNGSZUSTANDS EINER ELEKTROCHEMISCHEN BATTERIE IN ABHÄNGIGKEIT VON EINER ABBILDUNG DER LEERLAUFSPANNUNG

METHOD FOR DETERMINING THE STATE OF CHARGE AND STATE OF AGEING OF AN ELECTROCHEMICAL BATTERY AS A FUNCTION OF A MAPPING OF THE OPEN CIRCUIT VOLTAGE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **23.10.2018 FR 1859765**

(43) Date de publication de la demande:
**01.09.2021 Bulletin 2021/35**

(73) Titulaire: **PSA Automobiles SA
78300 Poissy (FR)**

(72) Inventeur: **BAGHDADI, Issam
78600 Le Mesnil Le Roi (FR)**

(56) Documents cités:
**WO-A1-2017/050944     WO-A2-2008/053410**

EP 3 870 985 B1

**Description**

Le domaine de l'invention concerne la gestion d'un système de batterie électrochimique et plus précisément un procédé de détermination de paramètres d'état de ladite batterie en fonction d'une cartographie de la tension à circuit ouvert.

Les véhicules hybrides et véhicules électriques embarquent des systèmes de batterie de puissance munis d'accumulateurs électrochimiques (appelés également cellules) destinés à alimenter les machines motrices électriques du véhicule. Ces systèmes ont aujourd'hui un rôle essentiel pour améliorer les performances énergétiques du véhicule en termes de réduction de la consommation de carburant, d'autonomie de roulage électrique et de puissance de motorisation. Par ailleurs, de nombreuses fonctions de motorisation du groupe motopropulseur dépendent des valeurs des indicateurs d'états du système de batterie, tel le niveau d'état de charge et l'état de vieillissement du système de batteries désignés respectivement par les acronymes anglais SOC pour « State of Charge » et SOH pour « State of Health ». Par exemple, les décisions de démarrage d'un moteur thermique, le choix entre un mode de roulage hybride ou tout électrique, ou encore des fonctions de navigation de planification de parcours reposent bien souvent sur le niveau d'état de charge du système de batterie. La précision et la mise à jour des indicateurs d'état sont donc cruciales pour le fonctionnement et l'agrément de conduite du véhicule. L'unité de commande du système de batterie, couramment appelée par l'acronyme BMS pour « Battery management System » en anglais, a pour tâche d'estimer en temps réels ces indicateurs d'état.

Parmi ces indicateurs, l'état de vieillissement est indispensable pour la gestion du système de batterie. En effet, l'état de vieillissement permet de quantifier la quantité d'énergie maximale que peut délivrer la batterie après une charge complète. On connait de l'état de la technique le document WO2015049300A1 dans lequel la caractéristique de la chute de courant en recharge à tension constante évolue linéairement avec l'état de vieillissement de la batterie. Ce courant décroit exponentiellement avec le temps. De plus, le document WO2017050944A1 décrit un procédé exploitant la linéarité de la relation entre la tension à circuit ouvert et l'état de vieillissement. On connait également le document CN106918789A décrivant un procédé d'estimation en temps réel de l'état de charge et de l'état de vieillissement. Le procédé surmonte un problème de correction de paramètres de modèle de circuit. La détermination de l'état de charge et de l'état de vieillissement se fait par l'intermédiaire d'une optimisation paramétrique d'un modèle complexe à circuits électriques équivalents de près de vingt paramètres. Les paramètres sont ensuite obtenus à partir de la mise à jour des paramètres du modèle après une optimisation par essaims particuliers. Cette solution présente le désavantage de requérir des ressources de calcul importantes pouvant empêcher son déploiement dans des applications embarquées de véhicule automobile contraintes en moyen de calcul et d'énergie. On connait également les documents CN105548898A et US20150377974A1 présentant les mêmes désavantages. Une méthode décrite dans le document KR20160002309A repose sur l'exploitation de l'hystérésis entre la charge et la décharge entre deux instants distincts pour la détermination de la courbe de tension à vide.

WO 2008/053410 A2 divulgue la détermination de l'état de charge d'une batterie lorsque la batterie n'est pas en équilibre.

Il existe donc un besoin de palier les problèmes précités. Un objectif de l'invention est de proposer une solution nécessitant peu de ressources de calcul pour estimer en temps réel les paramètres d'état de charge et d'état de vieillissement d'un système de batterie. Un autre objectif de l'invention est de proposer une solution de gestion d'un système de batterie embarqué ayant des performances optimisées de consommation électrique.

Plus précisément, l'invention concerne un procédé de détermination du paramètre d'état de vieillissement d'un système de batterie électrochimique, le procédé étant exécuté par une unité de commande du système de batterie et comportant les étapes successives suivantes :

-    la détection d'un premier instant où la batterie atteint une limite de référence d'état de charge lors d'une phase de charge ou de décharge, ladite limite de référence pouvant être la limite d'état de charge complet ou la limite d'état de décharge complet,

-    la détection d'un deuxième instant de début d'une phase de relaxation de la batterie,

-    la mesure en continu d'un signal de tension aux bornes de la batterie en relaxation,

-    l'estimation de la tension à circuit ouvert à partir du signal de tension mesuré en relaxation, le procédé étant remarquable en ce qu'il comporte en outre les étapes suivantes :

-    la détermination d'un paramètre d'état de charge relatif de la batterie au deuxième instant, le paramètre d'état de charge relatif correspondant à un état de charge calculé, en fonction d'une quantité d'énergie chargée ou déchargée depuis le premier instant, par rapport à la capacité nominale de la batterie,

- l'estimation du paramètre d'état de vieillissement en fonction de ladite tension à circuit ouvert et dudit paramètre d'état de charge relatif par lecture d'une cartographie prédéterminée fournissant des valeurs prédéterminées d'un paramètre d'état en fonction de valeurs prédéterminées de la tension à circuit ouvert, ledit paramètre d'état étant dépendant du paramètre de l'état de charge relatif et du paramètre de l'état de vieillissement.

Selon une variante, le procédé comporte en outre le calcul du paramètre d'état de charge réel en fonction du paramètre d'état de charge relatif et dudit paramètre d'état de vieillissement.

Selon une variante, pour déterminer le paramètre d'état de charge relatif, le procédé comporte la mesure de ladite quantité d'énergie chargée ou déchargée par un moyen de mesure ampérométrique du système de batterie entre le premier instant et le deuxième instant.

L'invention prévoit également un procédé de détermination de l'état de charge réel d'un système de batterie électrochimique, le procédé étant exécuté par une unité de commande du système de batterie et comportant les étapes successives suivantes :

- la détection d'un premier instant de début d'une phase de relaxation de la batterie,

- la mesure en continu d'un signal de tension aux bornes de la batterie en relaxation,

- l'estimation de la tension à circuit ouvert à partir du signal de tension mesurée en relaxation à un deuxième instant, le procédé étant remarquable en ce qu'il comporte en outre les étapes suivantes :

- la détermination d'un paramètre d'état de vieillissement de la batterie,

- l'estimation d'un paramètre d'état de charge relatif en fonction de ladite tension à circuit ouvert et dudit paramètre de vieillissement par lecture d'une cartographie prédéterminée fournissant des valeurs prédéterminées d'un paramètre d'état en fonction de valeurs prédéterminées de la tension à circuit ouvert, ledit paramètre d'état étant dépendant du paramètre de l'état de charge relatif et du paramètre de l'état de vieillissement, l'état de charge relatif correspondant à un état de charge calculé en fonction d'une quantité d'énergie, chargée ou déchargée depuis un état de charge ou de décharge complet, par rapport à la capacité nominale de la batterie,

- le calcul du paramètre d'état de charge réel en fonction du paramètre d'état de charge relatif et dudit paramètre d'état de vieillissement.

Selon une variante du procédé de détermination de l'état de charge réel, la détermination du paramètre d'état de vieillissement est estimée par un moyen d'estimation du paramètre d'état de vieillissement du système de batterie.

Plus précisément, le moyen d'estimation du paramètre de vieillissement calcule ledit paramètre de vieillissement en fonction du paramètre de tension à circuit ouvert.

Selon une variante préférentielle, le procédé comporte en outre, pour l'estimation de la tension à circuit ouvert :

- le calcul en continu durant la relaxation de la batterie d'un signal logarithmique de la tension dépendant dudit signal de tension en fonction de la valeur sous forme logarithmique du temps écoulé à partir du début de la relaxation,

- la détection d'un point d'inflexion du signal logarithmique de la tension,

- le calcul du paramètre de tension à circuit ouvert symétriquement par rapport au point d'inflexion en fonction au moins de la valeur du signal logarithmique à l'instant de détection dudit point d'inflexion.

L'invention prévoit également une unité de commande d'un système de batterie comportant une batterie électrochimique, ladite unité de commande comportant en outre une mémoire dans laquelle est enregistrée une cartographie prédéterminée apte à délivrer des valeurs prédéterminées d'un paramètre d'état en fonction de valeurs prédéterminées de la tension à circuit ouvert, ledit paramètre d'état étant dépendant d'un paramètre de l'état de charge relatif et d'un paramètre de l'état de vieillissement, l'état de charge relatif correspondant à un état de charge calculé en fonction d'une quantité d'énergie, chargée ou déchargée depuis un état de charge ou de décharge complet, par rapport à la capacité nominale de la batterie. Selon l'invention, l'unité de commande comporte les moyens de mettre en œuvre le procédé de détermination de l'état de vieillissement et le procédé de détermination de l'état de charge réel selon l'un quelconque des modes de réalisation précédents.

L'invention concerne également un véhicule automobile comportant ladite unité de commande.

L'invention concerne également un produit programme-ordinateur comprenant des instructions qui, lorsque le programme est exécuté par une unité de commande du système de batterie, conduisent celui-ci à mettre en œuvre l'un quelconque des modes de réalisation du procédé conformément à l'invention.

Grâce à l'invention, un système de gestion d'une batterie électrochimique est en capacité d'estimer, avec précision et sans recourir à des calculs complexes, simultanément la valeur d'un état de vieillissement et d'un état de charge réel de la batterie. La cartographie représentant l'état de charge relatif associé à l'état de vieillissement délivre par interpolation à partir du paramètre de tension à circuit ouvert l'état du système de batterie. L'usage de la cartographie améliore la précision du pilotage en temps réel d'un groupe motopropulseur de véhicule. Par ailleurs, l'estimation simultanée du couple état de charge/état de vieillissement exécutée par le procédé selon l'invention a pour avantage de mettre en œuvre un contrôle de diagnostic des capteurs de tension et/ou ampérométriques si de plus le système de gestion de la batterie est muni d'un moyen complémentaire d'estimation de l'état de vieillissement.

D'autres caractéristiques et avantages de la présente invention apparaitront plus clairement à la lecture de la description détaillée qui suit comprenant des modes de réalisation de l'invention donnés à titre d'exemples nullement limitatifs et illustrés par les dessins annexés, dans lesquels :

[Fig. 1] représente une unité de commande d'un système de batterie apte à mettre en œuvre le procédé selon l'invention.

[Fig. 2] représente un synoptique d'un algorithme du procédé de détermination de l'état de vieillissement et de l'état de charge réel d'une batterie électrochimique.

[Fig. 3] représente une cartographie selon l'invention mémorisée dans une unité de commande d'un système de batterie apte à délivrer des valeurs de la tension à circuit ouvert en fonction de valeurs d'un paramètre d'état égal au produit d'un état de charge relatif et de l'état de vieillissement.

L'invention vise à estimer en temps réel le paramètre d'état de vieillissement et le paramètre d'état de charge réel par lecture d'une cartographie prédéterminée délivrant des valeurs prédéterminées d'un paramètre, associant un état de charge relatif et l'état de vieillissement, en fonction du paramètre de tension à circuit ouvert. A cet effet, l'invention propose à la fois un procédé d'estimation du paramètre d'état de vieillissement et un procédé d'estimation du paramètre d'état de charge exploitant ladite cartographie prédéterminée.

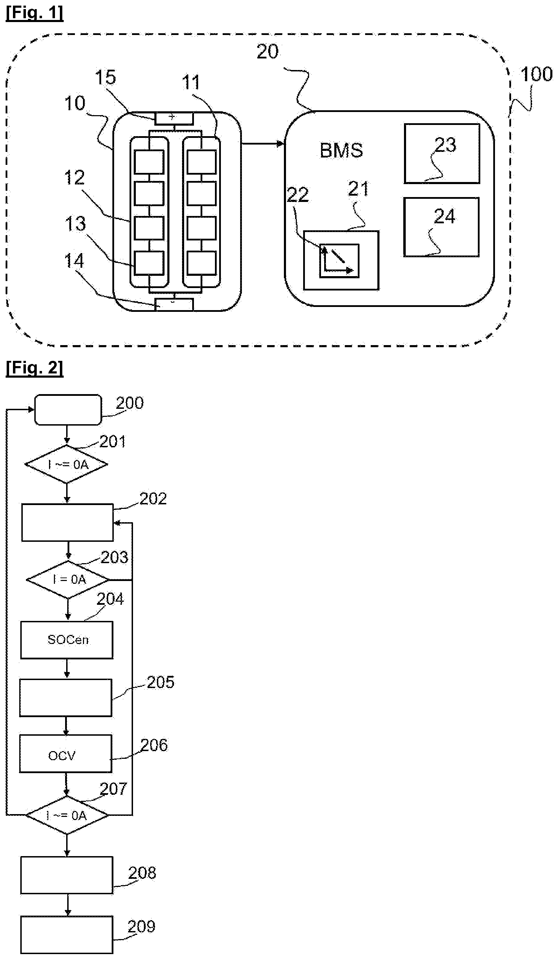

La figure 1 illustre schématiquement un système de batterie 100 destiné à équiper un véhicule automobile électrique comprenant une pluralité d'accumulateurs électrochimiques. Le système de batterie 100 comporte un module d'accumulateurs électrochimiques 10 et une unité de commande 20 pour la gestion du module 10. Typiquement, dans le cas d'une application de groupe motopropulseur automobile hybride électrique ou entièrement électrique, un système de batterie des machines motrices peut être équipé d'une pluralité de modules permettant le stockage et la restitution d'énergie électrique. Le module 10 peut être adressé individuellement par le système de batterie 100. Le module 10 comporte deux bornes de connexion 15, 14 pouvant fournir une tension électrique et un courant électrique déterminés en fonction du nombre de cellules électriques 13 assemblées en série et/ou en parallèle. Par exemple, le module 10 de cellules unitaires 13 comporte deux rangées 11, 12 ou plus montées en parallèle, chaque rangée étant constituée de cellules électriques unitaires 13 connectées en série.

Le système de batterie électrochimique 100 est de technologie de type Lithium, Li-ion, ou autres. Il est bien entendu que le système de batterie 100 et le procédé selon l'invention s'applique à d'autres applications, plus généralement à tout dispositif électrique ou électronique requérant une alimentation électrique constituée d'accumulateurs électrochimiques. Dispositifs portables, ordinateurs, installation d'alimentation électriques, satellites et bancs de test et de calibration sont des exemples d'une liste non exhaustive pour lesquels l'invention peut s'appliquer.

Le procédé est exécutable pour déterminer le paramètre de vieillissement et d'état de charge de chacun des modules de batterie adressable individuellement d'un système de batterie via des bornes de connexion électrique dudit module, ou d'un système dans son ensemble, ou bien encore d'une cellule unitaire lorsque celle-ci est adressable individuellement.

L'unité de commande 20 est un calculateur électronique à circuits intégrés muni d'un processeur et de mémoires électroniques pour exécuter le procédé de détermination du paramètre de vieillissement d'un module de batterie électrochimique. L'unité de commande 20 comporte des moyens 23 de mesure de la tension et du courant du module 10 (capteur de tension, capteur ampérométrique), des moyens de détection d'une phase de relaxation du module de batterie, plus précisément la détection d'un courant nul aux bornes du module, et des moyens de calcul pour opérer les étapes de calcul du procédé qui seront décrites ci-après. L'unité de commande comporte des moyens pour enregistrer les indicateurs d'état d'un module, tels l'indicateur de tension à circuit ouvert, l'indicateur d'état de vieillissement SOH et l'indicateur d'état de charge SOC par exemple à des fins de gestion du système de batterie au cours de la vie d'utilisation du véhicule. On ajoutera que selon l'application l'unité de commande est un système de gestion de la batterie embarqué (par exemple BMS d'un véhicule automobile) ou tout type de dispositif de contrôle de la batterie (ordinateur, application de gestion distante, ou ordinateur de banc de test).

De plus, l'unité de commande comporte optionnellement un moyen 24 de détermination en temps réel du paramètre d'état de vieillissement de la batterie. Le moyen 24 peut être utilisé judicieusement en coopération du procédé selon l'invention pour diagnostiquer le fonctionnement des moyens 23 de capteurs de tension, de courant et de calcul ampérométrique et/ou le propre fonctionnement du moyen 24. Par exemple, le moyen 24 détermine le paramètre de vieillissement à partir d'une des méthodes divulguées par les documents cités de l'état de la technique.

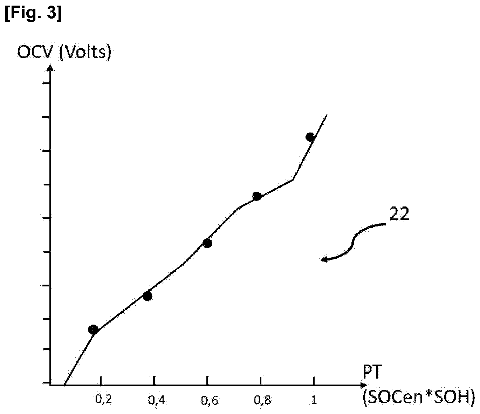

De plus, l'unité de commande 20 comporte un module de calcul 21 pour estimer en temps réel l'état de vieillissement et/ou l'état de charge réel du module de batterie 10 selon le procédé de l'invention. A cet effet, le module de calcul 21 comporte une mémoire sur laquelle est enregistrée une cartographie prédéterminée 22 permettant de délivrer des valeurs prédéterminées d'un paramètre d'état PT égal au produit d'un paramètre de l'état de charge relatif et du paramètre de l'état de vieillissement en fonction de valeurs prédéterminées de la tension à circuit ouvert. En figure 3, une représentation de la cartographie 22 est fournie. Le paramètre d'état PT est égal à la relation suivante, où SOCen est l'état de charge relatif et SOH l'état de vieillissement :

[Math 1]

$$PT = SOCen * SOH$$

L'état de vieillissement est un ratio en pourcentage de la valeur de la capacité réelle de la batterie à un instant donné par rapport à la capacité nominale de la batterie. La capacité nominale étant la valeur de référence fournie par le constructeur indiquant la quantité d'énergie délivrable à un état de charge complet pour un état neuf de la batterie. Pour une valeur de 100% du paramètre d'état de vieillissement, la batterie est considérée comme étant neuve et pour une valeur de 80%, la batterie est capable à un état de charge complet de délivrer 80% de la capacité nominale de la batterie.

Le paramètre d'état de charge relatif correspond à un état de charge calculé, en fonction d'une quantité d'énergie chargée ou déchargée depuis une limite de référence d'état de charge pouvant être la limite d'état de charge complet ou la limite d'état de décharge complet, par rapport à la capacité nominale de la batterie. Plus précisément, l'état de charge relatif se calcule tout d'abord en mesurant la quantité d'énergie déchargée depuis un état de charge complet ou la quantité d'énergie chargée depuis un état de décharge complet. Une fois ladite quantité d'énergie mesurée, on calcule le ratio de cette quantité d'énergie par rapport à la capacité nominale de la batterie. Cette valeur intermédiaire est exploitée par le procédé selon l'invention pour déterminer au moyen d'une lecture de la cartographie des valeurs en temps réel de l'état de charge et de l'état de vieillissement.

On précise que l'état de charge relatif se différencie de l'état de charge réel dit également absolu. Ce dernier correspond à un ratio de quantité d'énergie restituable par rapport à la capacité réelle de la batterie à un instant donné.

Par ailleurs, la tension à circuit ouvert, appelée également par l'acronyme anglais OCV « Open Circuit Voltage », est mesurée à courant nul, à l'équilibre thermodynamique d'un accumulateur électrique. L'état à courant nul d'une batterie est couramment désigné par le terme relaxation. Comme on le sait, cet équilibre n'est atteint qu'après une durée assez longue, souvent supérieure à une heure. Une variante de l'invention qui sera décrite plus précisément dans la suite de la description permet d'estimer cette valeur après une durée d'environ quelques dizaines de secondes à partir d'un point d'inflexion d'un signal dépendant de la courbe de tension en relaxation.

La figure 2 représente un premier mode de réalisation du procédé pour déterminer l'état de vieillissement et l'état de charge réel d'une batterie électrochimique. A une première étape 200, à un premier instant la batterie est dans un état de charge complet, ou un état de décharge complet. L'état de charge ou décharge complet correspond à la limite de référence qu'il est nécessaire de détecter pour calculer le paramètre d'état de charge relatif exploitée par la cartographie. A l'étape 200, l'état de charge relatif SOCen de la batterie est configurée à une valeur de 100% à charge complète ou à une valeur de référence correspondant à un état de décharge complète.

A une deuxième étape 201, le procédé détecte un courant I non nul aux bornes de l'accumulateur. Ensuite, à une troisième étape 202, le procédé mesure en continu la quantité d'énergie Qm, quantité déchargée ou la quantité d'énergie chargée selon respectivement si l'état de charge initial de l'étape 200 est un état de charge complet ou un état de décharge complet. La quantité d'énergie Qm est mesurée par le capteur de courant traversant les bornes de la batterie et calculée par comptage ampérométrique par l'unité de commande.

A une quatrième étape 203, le procédé détecte à un deuxième instant le début d'une phase de relaxation. La phase de relaxation se caractérise par un courant I nul aux bornes de la batterie.

Ensuite, à une cinquième étape, le procédé détermine la valeur de l'état de charge relatif SOCen au deuxième instant ou à un quelconque instant durant la phase de relaxation, à partir de la quantité d'énergie mesuré Qm par comptage ampérométrique lors de l'étape 202 et de la valeur de la capacité nominale Cn connue et enregistrée en mémoire de l'unité de commande selon la relation suivante à partir d'un état initial de charge complète :

[Math 2]

$$SOCen = (Cn - Qm)/Cn,$$

Ou, selon la relation suivante à partir d'un état initial de décharge complète :

[Math 3]

$$SOCen = Qm/Cn$$

A une sixième étape 205, le procédé comporte la mesure de la tension aux bornes de la batterie durant la phase de relaxation par l'unité de commande.

A une septième étape 206, le procédé comporte l'estimation du paramètre de la tension à circuit ouvert OCV. Le paramètre OCV est estimé lorsque la batterie a atteint l'équilibre thermodynamique par mesure de la tension Uacc aux bornes de la batterie, ou de façon connue en soi par calcul de modélisation à partir des premières données de la tension mesurée Uacc.

Selon une variante de l'invention, pour réduire le temps d'estimation du paramètre de la tension à circuit ouvert OCV à quelques dizaines de secondes, ce dernier est calculé par symétrie par rapport à un point d'inflexion d'un signal logarithmique de la tension mesurée en relaxation.

A cet effet, lors de l'étape 206, le procédé comporte les sous-étapes suivantes :

[0038] - le calcul en continu durant la relaxation de la batterie d'un signal logarithmique de la tension dépendant dudit signal de tension Uacc en fonction de la valeur sous forme logarithmique du temps écoulé à partir du deuxième instant de détection du début la phase de relaxation,

- la vérification si le signal logarithmique comporte un point d'inflexion,

- et, en cas de détection d'au moins un point d'inflexion à un instant d'inflexion, l'estimation consiste à calculer le paramètre de tension à circuit ouvert symétriquement par rapport au point d'inflexion en fonction au moins de la valeur du signal logarithmique audit instant d'inflexion.

Plus précisément, selon cette variante le signal logarithmique est une première représentation f1 dudit signal de tension Uacc en fonction de la valeur du temps sous forme logarithmique, où

[Math 4]

$$f1: \log(t) \rightarrow Uacc(t)$$

Selon une autre variante, le signal logarithmique est une deuxième représentation f2 dudit signal de tension sous une première forme logarithmique en fonction de la valeur du temps sous forme logarithmique, où

[Math 5]

$$f2: \log(t) \rightarrow \log(Uacc(t))$$

Selon une autre variante, le signal logarithmique est une troisième représentation f3 dudit signal de tension Uacc sous une deuxième forme logarithmique en fonction de la valeur du temps sous forme logarithmique, où

[Math 6]

$$f3: \log(t) \rightarrow \log\left(\log\left(Uacc(t)\right)\right)$$

La fonction f3 est préférentiellement choisie du fait que le signal logarithmique SF du signal de tension est proportionnel au volume du réactif en cours de transformation de phase lors de la relaxation. Le procédé exploite ainsi judicieusement le comportement attendu d'évolution en forme de sigmoïde du signal logarithmique. Cette évolution symétrique par rapport au point d'inflexion est représentative de la transformation de phase en cours lors d'une réaction de relaxation de la batterie. De plus, pour vérifier la présence d'un point d'inflexion sur la courbe du signal logarithmique, l'unité de commande calcule le signal de dérivée seconde du signal logarithmique SF. Il est bien entendu que d'autres variantes calculatoires de détection d'un point d'inflexion sont envisageables.

Revenons maintenant au déroulement de la séquence du procédé. A une huitième étape 207, lorsque l'unité de commande détecte un courant I non nul aux bornes de la batterie, le procédé retourne à l'étape 202 ou à l'étape initiale 200 si une limite de référence d'état de charge est atteinte.

A une neuvième étape 208, le procédé comporte l'estimation du paramètre d'état de vieillissement en fonction de ladite tension à circuit ouvert OCV et dudit paramètre d'état de charge relatif SOCen par lecture de la cartographie prédéterminée fournissant des valeurs prédéterminées du paramètre d'état PT. Plus précisément, la paramètre d'état de vieillissement est calculé selon la relation suivante :

[Math 7]

$$SOH = PT(OCV)/SOCen$$

Où PT(OCV) est la valeur du paramètre d'état PT délivrée par la cartographie pour la tension OCV estimée lors de l'étape 206 conjointement à la valeur de l'état de charge relatif calculée lors de l'étape 204.

Une fois que le paramètre d'état de vieillissement SOH est déterminé à partir de la cartographie, l'unité de commande calcule optionnellement lors de l'étape 208 le paramètre d'état de charge réel SOCr en fonction de l'état de charge relatif. Plus précisément, l'état de charge réel est calculé selon la relation suivante :

[Math 8]

$$SOCr = (SOH - 100 + SOCen)/SOH$$

L'invention prévoit un deuxième mode de réalisation du procédé selon l'invention pour estimer le paramètre d'état de charge réel d'une batterie. Le deuxième mode de réalisation se différencie du premier mode de réalisation en ce qu'il consiste à estimer dans un premier temps le paramètre d'état de vieillissement de la batterie par un moyen spécifique, tel le module 24 de l'unité de commande la figure 1 pour ensuite estimer le paramètre d'état de charge relatif SOCen. Le procédé comporte les étapes suivantes :

- la détection d'un premier instant de début d'une phase de relaxation de la batterie,

- la mesure en continu d'un signal de tension aux bornes de la batterie en relaxation,

- l'estimation de la tension à circuit ouvert OCV à partir du signal de tension mesurée en relaxation à un deuxième instant,

- la détermination du paramètre d'état de vieillissement de la batterie par l'unité de commande,

- puis l'estimation d'un paramètre d'état de charge relatif SOCen en fonction de ladite tension à circuit ouvert OCV et dudit paramètre de vieillissement par lecture de la cartographie prédéterminée selon la relation suivante :

[Math 9]

$$SOCen = PT(OCV)/SOH$$

Enfin, le procédé comporte une étape de calcul du paramètre d'état de charge réel SOCr en fonction du paramètre d'état de charge relatif SOCen et dudit paramètre d'état de vieillissement SOH selon la relation suivante :

[Math 10]

$$SOCr = (SOH - 100 + SOCen)/SOH$$

Identiquement au premier mode de réalisation, pour réduire le temps de calcul du procédé, le paramètre de tension à circuit ouvert OCV peut être estimé par symétrie par rapport au point d'inflexion du signal logarithmique dépendant de la tension en relaxation.

On notera que selon ce deuxième mode de réalisation, les étapes de mesure ampérométrique et de calcul de la quantité d'énergie chargée ou déchargée à partir d'une limite de référence ne sont pas nécessaires.

En figure 3, on décrit plus précisément la cartographie prédéterminée 22 exploitée par le procédé pour estimer les paramètres SOH et SOCr. La cartographie est construite en étude sur banc de test ou est fournie par le constructeur du système batterie et comporte des valeurs prédéterminées de la tension à circuit ouvert OCV, exprimées en Volts et ici représentées sur l'axe des ordonnées, et des valeurs prédéterminées du paramètre d'état PT égal au produit de l'état de charge relatif SOCen et du paramètre de vieillissement.

Une méthode de mise en œuvre de la cartographie consiste, pour une pluralité d'états de vieillissement connus de la batterie, à déterminer la tension à circuit ouvert et l'état de charge relatif. Une fois la cartographie construite, celle-ci est enregistrée en mémoire de l'unité de commande pour l'exécution du procédé selon l'invention.

Le procédé a été validé sur une technologie de batterie de type lithium-ion à différents états de charge relatif après charge et après décharge et à différents états de vieillissement. On notera par ailleurs que la méthode n'est pas sensible à la température car l'estimation de la tension à circuit ouvert présente une faible dépendance à la température du système.

De plus, lorsque l'unité de commande comporte des moyens complémentaires d'estimation des deux paramètres d'état de charge et de vieillissement, par mesure, par calcul ou par modélisation, grâce au procédé selon l'invention l'unité de commande est apte à mettre en œuvre un diagnostic de contrôle de vérification de ces moyens complémentaires du fait de l'estimation conjointe desdits paramètres par le procédé. En cas de défaillance, de capteurs ampérométriques ou des moyens de calcul le disfonctionnement est détectable par le procédé.

**Revendications**

1. Procédé de détermination du paramètre d'état de vieillissement d'un système de batterie électrochimique, le procédé étant exécuté par une unité de commande du système de batterie et comportant les étapes successives suivantes :

   - la détection (200) d'un premier instant où la batterie atteint une limite de référence d'état de charge lors d'une phase de charge ou de décharge, ladite limite de référence pouvant être la limite d'état de charge complet ou la limite d'état de décharge complet,
   - la détection (203) d'un deuxième instant de début d'une phase de relaxation de la batterie,
   - la mesure (205) en continu d'un signal de tension aux bornes de la batterie en relaxation,
   - l'estimation (206) de la tension à circuit ouvert (OCV) à partir du signal de tension mesuré en relaxation,
   - le procédé étant **caractérisé en ce qu'**il comporte en outre les étapes suivantes :
   - la détermination (204) d'un paramètre d'état de charge relatif (SOCen) de la batterie au deuxième instant, le paramètre d'état de charge relatif correspondant à un état de charge calculé, en fonction d'une quantité d'énergie chargée ou déchargée depuis le premier instant, par rapport à la capacité nominale de la batterie,
   - l'estimation (208) du paramètre d'état de vieillissement en fonction de ladite tension à circuit ouvert (OCV) et dudit paramètre d'état de charge relatif (SOCen) par lecture d'une cartographie prédéterminée fournissant des valeurs prédéterminées d'un paramètre d'état (PT) en fonction de valeurs prédéterminées de la tension à circuit ouvert, ledit paramètre d'état (PT) étant dépendant du paramètre de l'état de charge relatif (SOCen) et du paramètre de l'état de vieillissement (SOH).

**2.** Procédé selon la revendication 1, **caractérisé en ce qu'**il comporte en outre le calcul du paramètre d'état de charge réel (SOCr) en fonction du paramètre d'état de charge relatif (SOCen) et dudit paramètre d'état de vieillissement (SOH).

**3.** Procédé selon la revendication 1 ou 2, **caractérisé en ce qu'**il comporte, pour déterminer le paramètre d'état de charge relatif (SOCen), la mesure (202) de ladite quantité d'énergie chargée ou déchargée par un moyen de mesure ampérométrique (23) du système de batterie entre le premier instant et le deuxième instant.

**4.** Procédé de détermination de l'état de charge réel (SOCr) d'un système de batterie électrochimique, le procédé étant exécuté par une unité de commande du système de batterie et comportant les étapes successives suivantes :

- la détection d'un premier instant de début d'une phase de relaxation de la batterie,
- la mesure en continu d'un signal de tension aux bornes de la batterie en relaxation,
- l'estimation de la tension à circuit ouvert (OCV) à partir du signal de tension mesurée en relaxation à un deuxième instant,
- le procédé étant **caractérisé en ce qu'**il comporte en outre les étapes suivantes :
- la détermination d'un paramètre d'état de vieillissement de la batterie,
- l'estimation d'un paramètre d'état de charge relatif (SOCen) en fonction de ladite tension à circuit ouvert (OCV) et dudit paramètre de vieillissement par lecture d'une cartographie prédéterminée fournissant des valeurs prédéterminées d'un paramètre d'état (PT) en fonction de valeurs prédéterminées de la tension à circuit ouvert, ledit paramètre d'état (PT) étant dépendant du paramètre de l'état de charge relatif (SOCen) et du paramètre de l'état de vieillissement (SOH), l'état de charge relatif (SOCen) correspondant à un état de charge calculé en fonction d'une quantité d'énergie, chargée ou déchargée depuis un état de charge ou de décharge complet, par rapport à la capacité nominale de la batterie,
- le calcul du paramètre d'état de charge réel (SOCr) en fonction du paramètre d'état de charge relatif (SOCen) et dudit paramètre d'état de vieillissement (SOH).

**5.** Procédé selon la revendication 4, **caractérisé en ce que** la détermination du paramètre d'état de vieillissement est estimée par un moyen d'estimation (24) du paramètre d'état de vieillissement du système de batterie.

**6.** Procédé selon la revendication 5, **caractérisé en ce que** le moyen d'estimation du paramètre de vieillissement calcule ledit paramètre de vieillissement en fonction du paramètre de tension à circuit ouvert (OCV).

**7.** Procédé selon l'une quelconque des revendications 1 à 6, **caractérisé en ce qu'**il comporte en outre, pour l'estimation de la tension à circuit ouvert (OCV) :

- le calcul en continu durant la relaxation de la batterie d'un signal logarithmique de la tension dépendant dudit signal de tension en fonction de la valeur sous forme logarithmique du temps écoulé à partir du début de la relaxation,
- la détection d'un point d'inflexion du signal logarithmique de la tension,
- le calcul du paramètre de tension à circuit ouvert (OCV) symétriquement par rapport au point d'inflexion en fonction au moins de la valeur du signal logarithmique à l'instant de détection dudit point d'inflexion.

**8.** Unité de commande d'un système de batterie comportant une batterie électrochimique, **caractérisée en ce qu'**elle comporte en outre une mémoire dans laquelle est enregistrée une cartographie prédéterminée apte à délivrer des valeurs prédéterminées d'un paramètre d'état (PT) en fonction de valeurs prédéterminées de la tension à circuit ouvert, ledit paramètre d'état (PT) étant dépendant d'un paramètre de l'état de charge relatif (SOCen) et d'un paramètre de l'état de vieillissement (SOH), l'état de charge relatif (SOCen) correspondant à un état de charge calculé en fonction d'une quantité d'énergie, chargée ou déchargée depuis un état de charge ou de décharge complet, par rapport à la capacité nominale de la batterie, et **en ce qu'**elle comporte les moyens de mettre en œuvre le procédé selon l'une quelconque des revendications 1 à 7.

**9.** Véhicule automobile comportant une unité de commande selon la revendication 8.

**Patentansprüche**

**1.** Verfahren zur Bestimmung des Alterungszustandsparameters eines elektrochemischen Batteriesystems, wobei das Verfahren von einem Steuergerät des Batteriesystems ausgeführt wird und die folgenden aufeinanderfolgenden Schritte umfasst:

- das Erfassen (200) eines ersten Zeitpunkts, an dem die Batterie während einer Lade- oder Entladephase eine Referenzgrenze des Ladezustands erreicht, wobei die Referenzgrenze die Grenze des vollen Ladezustands oder die Grenze des vollen Entladezustands sein kann,
- die Erfassung (203) eines zweiten Moments des Beginns einer Entspannungsphase der Batterie,
- die kontinuierliche Messung (205) eines Spannungssignals an den Klemmen der Batterie in Entspannung,
- Schätzung (206) der Leerlaufspannung (OCV) aus dem in Entspannung gemessenen Spannungssignal,
- wobei das Verfahren **dadurch gekennzeichnet ist, dass** es ferner die folgenden Schritte umfasst:
- die Bestimmung (204) eines relativen Ladezustandsparameters (SOCen) der Batterie zum zweiten Zeitpunkt, wobei der relative Ladezustandsparameter einem berechneten Ladezustand entspricht, gemäß einer Energiemenge, die von dem ersten geladen oder entladen wird Moment, verglichen mit der Nennkapazität der Batterie,
- Schätzung (208) des Alterungszustandsparameters als Funktion der Leerlaufspannung (OCV) und des relativen Ladezustandsparameters (SOCen) durch Lesen einer vorbestimmten Karte, die vorbestimmte Werte eines Zustandsparameters (PT) liefert, wie eine Funktion von vorbestimmten Werten der Leerlaufspannung, wobei der Zustandsparameter (PT) von dem Parameter des relativen Ladezustands (SOCen) und dem Parameter des Alterungszustands (SOH) abhängig ist.

2. Verfahren nach Anspruch 1, **dadurch gekennzeichnet, dass** es ferner das Berechnen des tatsächlichen Ladezustandsparameters (SOCr) als eine Funktion des relativen Ladezustandsparameters (SOCen) und des Alterungszustandsparameters (SOH) umfasst.

3. Verfahren nach Anspruch 1 oder 2, **dadurch gekennzeichnet, dass** es zur Bestimmung des relativen Ladezustandsparameters (SOCen) die Messung (202) der geladenen oder entladenen Energiemenge durch ein amperometrisches Messmittel (23) umfasst. des Batteriesystems zwischen dem ersten Zeitpunkt und dem zweiten Zeitpunkt.

4. Verfahren zum Bestimmen des tatsächlichen Ladezustands (SOCr) eines elektrochemischen Batteriesystems, wobei das Verfahren von einer Steuereinheit des Batteriesystems ausgeführt wird und die folgenden aufeinanderfolgenden Schritte umfasst:

- die Erkennung eines ersten Moments des Beginns einer Entspannungsphase der Batterie,
- die kontinuierliche Messung eines Spannungssignals an den Klemmen der Batterie in Entspannung,
- Abschätzung der Leerlaufspannung (OCV) aus dem in Relaxation gemessenen Spannungssignal zu einem zweiten Zeitpunkt,
- wobei das Verfahren **dadurch gekennzeichnet ist, dass** es ferner die folgenden Schritte umfasst:
- die Bestimmung eines Alterungszustandsparameters der Batterie,
- Schätzung eines relativen Ladezustandsparameters (SOCen) als Funktion der Leerlaufspannung (OCV) und des Alterungsparameters durch Lesen eines vorgegebenen Kennfelds, das vorgegebene Werte eines Zustands (PT) als Funktion vorgegebener Werte liefert der Leerlaufspannung, wobei der Zustandsparameter (PT) von dem Parameter des relativen Ladezustands (SOCen) und von dem Parameter des Alterungszustands (SOH) abhängig ist, wobei der relative Ladezustand (SOCen) entspricht auf einen Ladezustand, berechnet nach einer Energiemenge, geladen oder entladen aus einem Zustand vollständiger Ladung oder Entladung, in Bezug auf die Nennkapazität der Batterie,
- die Berechnung des aktuellen Ladezustandsparameters (SOCr) als Funktion des relativen Ladezustandsparameters (SOCen) und des Alterungszustandsparameters (SOH).

5. Verfahren nach Anspruch 4, **dadurch gekennzeichnet, dass** die Bestimmung des Alterungszustandsparameters durch Mittel zum Schätzen (24) des Alterungszustandsparameters des Batteriesystems geschätzt wird.

6. Verfahren nach Anspruch 5, **dadurch gekennzeichnet, dass** die Alterungsparameter-Schätzeinrichtung den Alterungsparameter als Funktion des Parameters der Leerlaufspannung (OCV) berechnet.

7. Verfahren nach einem der Ansprüche 1 bis 6, **dadurch gekennzeichnet, dass** es außerdem für die Schätzung der Leerlaufspannung (OCV) umfasst:

- die fortlaufende Berechnung eines logarithmischen Signals der Spannung während der Entspannung der Batterie in Abhängigkeit von dem Spannungssignal gemäß dem Wert in logarithmischer Form der seit dem Beginn der Entspannung verstrichenen Zeit,
- die Detektion eines Wendepunktes des logarithmischen Signals der Spannung,
- die Berechnung des Leerlaufspannungsparameters (OCV) symmetrisch zum Wendepunkt als Funktion mindestens des Werts des logarithmischen Signals zum Zeitpunkt der Detektion des Wendepunkts.

8. Steuereinheit eines Batteriesystems mit einer elektrochemischen Batterie, **dadurch gekennzeichnet, dass** sie ferner einen Speicher umfasst, in dem ein vorgegebenes Kennfeld aufgezeichnet ist, das in der Lage ist, vorgegebene Werte eines Zustandsparameters (PT) in Abhängigkeit von vorgegebenen Werten des offenen Stromkreises zu liefern Spannung, wobei der Zustandsparameter (PT) von einem Parameter des relativen Ladezustands (SOCen) und einem Parameter des Alterungszustands (SOH) abhängig ist, wobei der relative Ladezustand (SOCen) einem berechneten Ladezustand entspricht gemäß einer Energiemenge, geladen oder entladen aus einem vollständig geladenen oder entladenen Zustand in Bezug auf die Nennkapazität der Batterie, und dadurch, dass es die Mittel zum Ausführen des Verfahrens nach einem der Ansprüche 1 bis 7 umfasst.

9. Kraftfahrzeug mit einer Steuereinheit nach Anspruch 8.

**Claims**

1. Method for determining the aging state parameter of an electrochemical battery system, the method being executed by a control unit of the battery system and comprising the following successive steps:

   - the detection (200) of a first instant when the battery reaches a state-of-charge reference limit during a charging or discharging phase, said reference limit possibly being the full state-of-charge limit or the full state of discharge limit,
   - the detection (203) of a second moment of the start of a relaxation phase of the battery,
   - the continuous measurement (205) of a voltage signal across the terminals of the battery in relaxation,
   - estimation (206) of the open circuit voltage (OCV) from the voltage signal measured in relaxation,
   - the method being **characterized in that** it further comprises the following steps:
   - the determination (204) of a relative state of charge parameter (SOCen) of the battery at the second instant, the relative state of charge parameter corresponding to a calculated state of charge, according to a quantity of energy charged or discharged from the first moment, compared to the nominal capacity of the battery,
   - estimation (208) of the aging state parameter as a function of said open circuit voltage (OCV) and of said relative state of charge parameter (SOCen) by reading a predetermined map providing predetermined values of a state parameter (PT) as a function of predetermined values of the open circuit voltage, said state parameter (PT) being dependent on the parameter of the relative state of charge (SOCen) and on the parameter of the state of aging (SOH).

2. Method according to claim 1, **characterized in that** it further comprises calculating the actual state of charge parameter (SOCr) as a function of the relative state of charge parameter (SOCen) and of said aging state parameter ( SOH).

3. Method according to claim 1 or 2, **characterized in that** it comprises, in order to determine the relative state of charge parameter (SOCen), the measurement (202) of the said quantity of energy charged or discharged by an amperometric measuring means (23) of the battery system between the first instant and the second instant.

4. Method for determining the actual state of charge (SOCr) of an electrochemical battery system, the method being executed by a control unit of the battery system and comprising the following successive steps:

   - the detection of a first moment of the start of a relaxation phase of the battery,
   - the continuous measurement of a voltage signal across the terminals of the battery in relaxation,
   - estimation of the open circuit voltage (OCV) from the voltage signal measured in relaxation at a second instant,
   - the method being **characterized in that** it further comprises the following steps:
   - the determination of an aging state parameter of the battery,
   - estimation of a relative state of charge parameter (SOCen) as a function of said open circuit voltage (OCV) and of said aging parameter by reading a predetermined map providing predetermined values of a state (PT) as a function of predetermined values of the open circuit voltage, said state parameter (PT) being dependent on the parameter of the relative state of charge (SOCen) and on the parameter of the state of aging (SOH) ,

the relative state of charge (SOCen) corresponding to a state of charge calculated according to a quantity of energy, charged or discharged from a state of complete charge or discharge, with respect to the nominal capacity of the battery,
- the calculation of the actual state of charge parameter (SOCr) as a function of the relative state of charge parameter (SOCen) and of said state of aging parameter (SOH).

5. Method according to claim 4, **characterized in that** the determination of the aging state parameter is estimated by means for estimating (24) the aging state parameter of the battery system.

6. Method according to claim 5, **characterized in that** the aging parameter estimating means calculates said aging parameter as a function of the open circuit voltage (OCV) parameter.

7. Method according to any one of claims 1 to 6, **characterized in that** it further comprises, for the estimation of the open circuit voltage (OCV):

 - the continuous calculation during the relaxation of the battery of a logarithmic signal of the voltage depending on said voltage signal according to the value in logarithmic form of the time elapsed from the start of the relaxation,
 - the detection of a point of inflection of the logarithmic signal of the voltage,
 - the calculation of the open circuit voltage parameter (OCV) symmetrically with respect to the point of inflection as a function at least of the value of the logarithmic signal at the instant of detection of said point of inflection.

8. Control unit of a battery system comprising an electrochemical battery, **characterized in that** it further comprises a memory in which is recorded a predetermined map capable of delivering predetermined values of a state parameter (PT) depending of predetermined values of the open circuit voltage, said state parameter (PT) being dependent on a parameter of the relative state of charge (SOCen) and of a parameter of the state of aging (SOH), the relative state of charge (SOCen) corresponding to a state of charge calculated according to a quantity of energy, charged or discharged from a state of complete charge or discharge, with respect to the nominal capacity of the battery, and **in that** it includes the means to implement the method according to any one of claims 1 to 7.

9. Motor vehicle comprising a control unit according to claim 8.

[Fig. 1]

[Fig. 2]

[Fig. 3]

**RÉFÉRENCES CITÉES DANS LA DESCRIPTION**

**Documents brevets cités dans la description**

- WO 2015049300 A1
- WO 2017050944 A1
- CN 106918789 A
- CN 105548898 A
- US 20150377974 A1
- KR 20160002309 A
- WO 2008053410 A2